(19) Europäisches Patentamt
European Patent Office
Office européen des brevets

(11) **EP 2 056 116 B1**

(12) **FASCICULE DE BREVET EUROPEEN**

(45) Date de publication et mention de la délivrance du brevet:
**11.07.2018 Bulletin 2018/28**

(51) Int Cl.:
***G01R 31/40*** *(2014.01)*     ***G01R 31/02*** *(2006.01)*
***G01R 27/26*** *(2006.01)*

(21) Numéro de dépôt: **08354066.6**

(22) Date de dépôt: **01.10.2008**

(54) **Procédé et dispositif de prédiction de défaillances de condensateur électrolytique, convertisseur et alimentation sans interruption equipés d'un tel dispositif**

Verfahren und Vorrichtung zur Vorhersage von Störungen eines Elekrolytkondensators, Wandler und unterbrechungsfreie Stromversorgung, die mit einer solchen Vorrichtung ausgestattet sind

Method and device for predicting failures of an electrolytic capacitor, converter and uninterruptible power supply equipped with such a device

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **30.10.2007 FR 0707620**

(43) Date de publication de la demande:
**06.05.2009 Bulletin 2009/19**

(73) Titulaire: **MGE UPS Systems**
**38330 Montbonnot-Saint-Martin (FR)**

(72) Inventeurs:
- **Abdennadher, Karim**
  **38050 Grenoble Cedex 09 (FR)**
- **Rosset, Christophe**
  **38050 Grenoble Cedex 09 (FR)**
- **Rojat, Gérard**
  **38050 Grenoble Cedex 9 (FR)**
- **Venet, Pascal**
  **38050 Grenoble Cedex 09 (FR)**

(74) Mandataire: **Tripodi, Paul et al**
**Schneider Electric Industries SAS**
**Service Propriété Industrielle**
**World Trade Center - E1**
**5 Place Robert Schuman**
**38050 Grenoble Cedex 9 (FR)**

(56) Documents cités:
**EP-B- 1 198 715     US-A1- 2007 103 136**

- **PERISSE F ET AL: "Simple model of an electrolytic capacitor taking into account the temperature and aging time" ELECTRICAL ENGINEERING SPRINGER-VERLAG GERMANY, vol. 88, no. 2, janvier 2006 (2006-01), pages 89-95, XP002481419 ISSN: 0948-7921**
- **LEE D-C ET AL: "Online capacitance estimation of DC-link electrolytic capacitors for three-phase AC/DC/AC PWM converters using recursive least squares method" IEE PROCEEDINGS: ELECTRIC POWER APPLICATIONS, INSTITUTION OF ELECTRICAL ENGINEERS, GB, vol. 152, no. 6, 4 novembre 2005 (2005-11-04), pages 1503-1508, XP006025429 ISSN: 1350-2352**
- **IMAM A M ET AL: "Condition Monitoring of Electrolytic Capacitor in Power Electronic Circuits using Adaptive Filter Modeling" POWER ELECTRONICS SPECIALISTS, 2005 IEEE 36TH CONFERENCE ON JUNE 12, 2005, PISCATAWAY, NJ, USA,IEEE, 12 juin 2005 (2005-06-12), pages 601-607, XP010883269 ISBN: 978-0-7803-9033-1**

**Description**

DOMAINE TECHNIQUE DE L'INVENTION

L'invention concerne un procédé de prédiction de défaillances d'au moins un condensateur électrolytique comprenant :

- la mesure de la tension de l'ondulation entre les bornes de contact du condensateur,

- la mesure de la température du condensateur,

- la détermination (ou la mesure) du courant circulant dans le condensateur,

- la détermination de la valeur d'une résistance équivalente série du condensateur,

- la détermination de la valeur d'une résistance équivalente série théorique dudit condensateur en fonction de la température du condensateur,

- la comparaison de la valeur de la résistance équivalente série du condensateur avec la valeur équivalente série théorique dudit condensateur, et

- l'indication d'au moins une information représentative de l'état de vieillissement du condensateur.

L'invention concerne également un convertisseur d'une tension variable en tension continue comprenant au moins une ligne d'alimentation, au moins un condensateur électrolytique connecté sur une sortie dudit convertisseur, et un dispositif de prédiction de défaillances.
L'invention concerne, en outre, une alimentation sans interruption comportant un convertisseur d'une tension variable en tension continue et un onduleur.

ETAT DE LA TECHNIQUE

Les condensateurs électrolytiques sont généralement utilisés dans des convertisseurs d'énergie électrique pour le filtrage de la tension d'entrée ou de la tension de sortie. Ces convertisseurs peuvent être destinés à alimenter en tension continue des systèmes électroniques d'équipement pour lesquels tout arrêt peut être préjudiciable. Il a été constaté que la plupart des pannes de ces convertisseurs sont dues à une défaillance des condensateurs électrolytiques.
Il est connu de mettre en oeuvre des procédés permettant de déterminer l'état de vieillissement d'un condensateur. Le brevet européen EP 1 198 715 décrit un tel procédé comprenant :

- les mesures d'une tension de l'ondulation entre les bornes de contact du condensateur et d'un courant circulant dans le condensateur,
- la détermination de la valeur d'une résistance équivalente série du condensateur en fonction de ces mesures,
- la mesure de la température du condensateur,
- la détermination d'une résistance équivalente série théorique dudit condensateur, correspondant à un condensateur non défaillant en fonction de cette température du condensateur, et
- la comparaison des deux résistances équivalentes série pour déterminer une information représentative de l'état de vieillissement du condensateur.

Un problème technique des procédés de l'art antérieur est qu'ils ne permettent pas de déterminer la cause de la défaillance du condensateur électrolytique.

EXPOSE DE L'INVENTION

L'invention vise à remédier aux problèmes techniques des procédés de l'art antérieur en proposant un procédé de prédiction de défaillances d'au moins un condensateur électrolytique comprenant :

- la mesure de la tension de l'ondulation entre les bornes de contact du condensateur,

- la mesure de la température du condensateur,

- la détermination ou la mesure du courant circulant dans le condensateur,

- la détermination de la valeur d'une résistance équivalente série du condensateur,

- la détermination d'au moins une information représentative de l'état de vieillissement du condensateur à l'aide d'un modèle de détermination d'une résistance équivalente série théorique dudit condensateur en fonction de la température du condensateur, et

- l'indication de l'information représentative de l'état de vieillissement du condensateur.

Selon la présente invention, le procédé comporte la détermination de la valeur de la capacité du condensateur, les déterminations de la résistance équivalente série et de la capacité sont réalisées à l'aide d'un filtre numérique, et le procédé comporte l'indication d'une information représentative de la valeur de la capacité du condensateur et d'une information représentative d'au moins une cause associée à l'état de vieillissement dudit condensateur en fonction de la valeur de la capacité et de la résistance équivalente série du condensateur.

De préférence, le filtre numérique est un filtre de Kalman. Par exemple, le filtre de Kalman met en oeuvre un algorithme de type récursif.

Selon un mode de réalisation, le procédé comporte l'application aux bornes du condensateur d'une séquence binaire pseudo aléatoire.

L'invention concerne également un dispositif de prédiction de défaillances d'au moins un condensateur électrolytique comprenant :

- des moyens de mesure de la tension de l'ondulation entre les bornes de contact du condensateur,

- des moyens de mesure de la température du condensateur,

- des moyens de détermination ou de mesure du courant circulant dans le condensateur,

- une unité de traitement comportant des premiers moyens de traitement permettant de déterminer la valeur d'une résistance équivalente série du condensateur, et des seconds moyens de traitement permettant de déterminer au moins une information représentative de l'état de vieillissement du condensateur à partir d'un modèle de détermination d'une résistance équivalente série théorique dudit condensateur en fonction de la température du condensateur, et

- une interface de sortie connectée à l'unité de traitement et permettant d'indiquer l'information représentative de l'état de vieillissement du condensateur.

Dans le dispositif selon l'invention, les premiers moyens de traitement sont essentiellement constitués par un filtre numérique permettant, en outre, de déterminer la valeur de la capacité du condensateur, et l'interface de sortie permet d'indiquer, en outre, une information représentative de la valeur de la capacité du condensateur et une information représentative d'au moins une cause associée à l'état de vieillissement dudit condensateur en fonction de la valeur de la capacité et de la résistance équivalente série du condensateur.

De préférence, l'unité de traitement comporte des moyens d'identification d'au moins une cause associée à l'état de vieillissement du condensateur en fonction de la valeur de la capacité et de la résistance équivalente série dudit condensateur, et l'interface de sortie permet d'indiquer une information représentative d'au moins une cause de l'état de vieillissement.

De préférence, le dispositif comporte une unité de traitement annexe comportant des moyens d'identification d'au moins une cause associée à l'état de vieillissement du condensateur et destiné à être connectés à l'interface de sortie.

Selon un mode de réalisation, les premiers moyens de traitement comportent un filtre de Kalman pour déterminer les valeurs de la résistance équivalente série du condensateur et de la capacité du condensateur. De préférence, le filtre de Kalman met en oeuvre un algorithme de type récursif.

Selon un mode de réalisation, le procédé comporte des moyens d'application d'une séquence binaire pseudo aléatoire aux bornes du condensateur.

L'invention concerne également un convertisseur d'une tension variable en tension continue, par exemple un convertisseur de puissance, comprenant au moins une ligne d'alimentation, au moins un condensateur électrolytique connecté sur une sortie dudit convertisseur, et un dispositif de prédiction de défaillances, dans lequel le dispositif de prédiction de défaillances est tel que celui décrit précédemment et permet de prédire les défaillances du condensateur électrolytique.

De préférence, les moyens de détermination du courant circulant dans le condensateur sont connectés à des moyens de mesures d'un courant sur la ligne d'alimentation et à des moyens de mesures d'un courant dans une charge électrique.

De préférence, le convertisseur comporte une pluralité de condensateurs électrolytiques montés en parallèle, le dispositif de prédiction permettant de prédire les défaillances de ladite pluralité de condensateurs électrolytiques.

L'invention concerne également une alimentation sans interruption comportant un convertisseur d'une tension variable en tension continue et un onduleur, dans lequel le convertisseur est tel que celui décrit précédemment, l'onduleur étant connecté sur la sortie dudit convertisseur.

BREVE DESCRIPTION DES FIGURES

D'autres avantages et caractéristiques ressortiront plus clairement de la description qui suit de modes particuliers de réalisation de l'invention, donnés à titre d'exemples non limitatifs, et représentés dans les figures annexées.

La figure 1 représente schématiquement un convertisseur de puissance et un dispositif de prédiction de défaillances d'un condensateur électrolytique dudit convertisseur.

La figure 2 représente schématiquement une unité de traitement et une interface de sortie d'un dispositif de prédiction de défaillances d'un condensateur électrolytique.

Les figures 3a et 3b représentent respectivement un modèle de condensateur électrolytique et le modèle équivalent associé.

La figure 4 représente schématiquement les premiers moyens de traitement de l'unité de traitement permettant de déterminer la valeur d'une résistance équivalente série et de la valeur de la capacité du condensateur.

La figure 5 représente schématiquement les seconds moyens de traitement de l'unité de traitement permettant de déterminer au moins une information représentative de l'état de vieillissement du condensateur.

La figure 6 représente schématiquement l'unité de traitement et une interface de sortie d'un dispositif de prédiction de défaillances d'un condensateur électrolytique selon un autre mode de réalisation.

DESCRIPTION DETAILLEE D'UN MODE DE REALISATION

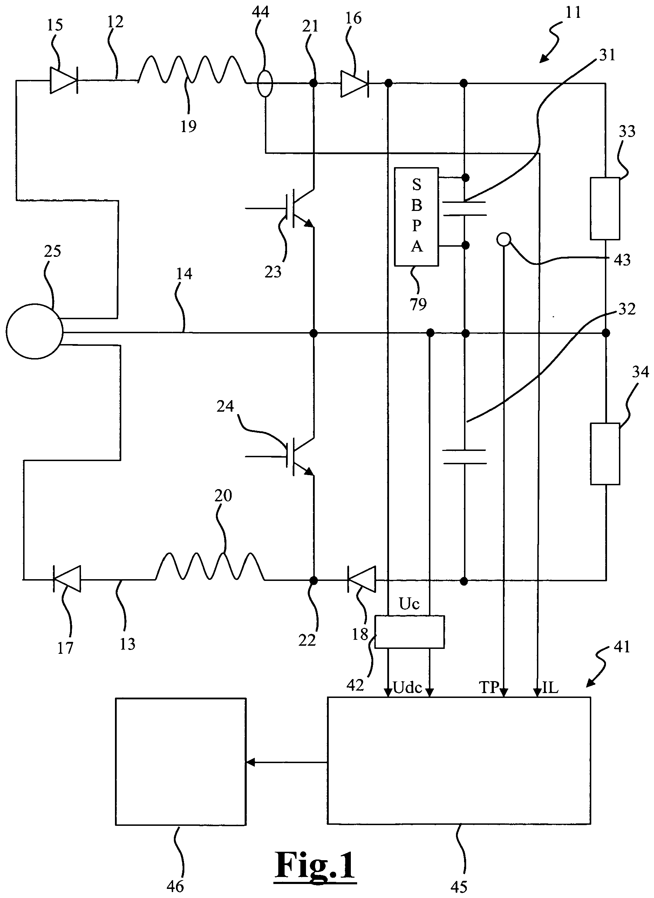

Le dispositif de prédiction de défaillances selon l'invention peut être appliqué à n'importe quel convertisseur, en particulier un convertisseur de puissance, par exemple du type PFC, c'est à dire permettant une correction du facteur de puissance. Un convertisseur d'une tension alternative en tension continue de ce type est représenté à la figure 1. Le convertisseur 11 est alimenté par une source de tension alternative de type sinusoïdale 25. La source 25 est connectée par l'intermédiaire d'un bus positif 12 dans lequel le sens du courant est imposé par l'intermédiaire d'une diode 15, d'un bus négatif 13 dans lequel le sens du courant est imposé par l'intermédiaire d'une diode 17, et d'un conducteur de neutre 14. Chaque bus comporte une inductance 19, 20 pour stocker l'énergie d'entrée lorsque des interrupteurs commandés 23, 24 sont en position fermée et pour restituer cette énergie à des condensateurs 31, 32 à travers des diodes de roue libre 16, 18, lorsque les interrupteurs commandés 23, 24 sont en position ouverte. Les interrupteurs commandés sont interposés entre l'un des points du circuit référencés 21, 22 et le conducteur de neutre 14. Ainsi, lorsqu'un interrupteur commandé est en position fermée, un contact électrique est établi entre l'un des points 21, 22 et le conducteur de neutre 14. De même, lorsque cet interrupteur commandé est en position ouverte, ce contact électrique est supprimé. Les interrupteurs commandés 23, 24 sont commandés par des moyens de commande non représentés. Les interrupteurs commandés 23, 24 peuvent être des transistors, par exemple de type IGBT, à effet de champ ou autres. La charge 33, 34 est donc alimentée par la tension variable ainsi obtenue.

Le potentiel électrique de référence du conducteur de neutre est imposé par la référence de neutre de l'alimentation 25. Ces condensateurs sont généralement du type électrolytique et sont souvent à l'origine des pannes des convertisseurs de puissance. Toute défaillance des condensateurs 31, 32 peut entraîner des arrêts intempestifs ou une détérioration du convertisseur de puissance, et donc une perte de production. Souvent, sur des installations dites sensibles, ces condensateurs sont montés en redondance.

Pour remédier à ces inconvénients, le convertisseur représenté à la figure 1 comporte un dispositif 41 de prédiction de défaillances. Pour simplifier la figure 1, le dispositif de prédiction de défaillances représenté est appliqué au seul condensateur 31. Un dispositif identique pourrait être est appliqué au condensateur 32.

Le dispositif de prédiction 41 représenté à la figure 1 comporte des moyens de mesures, tels que :

- des moyens de mesure 42 de la tension Udc de l'ondulation entre les bornes de contact du condensateur 31,

- des moyens de mesure 43 de la température TP du condensateur, et

- des moyens de mesure 44 du courant IL circulant dans le bus positif.

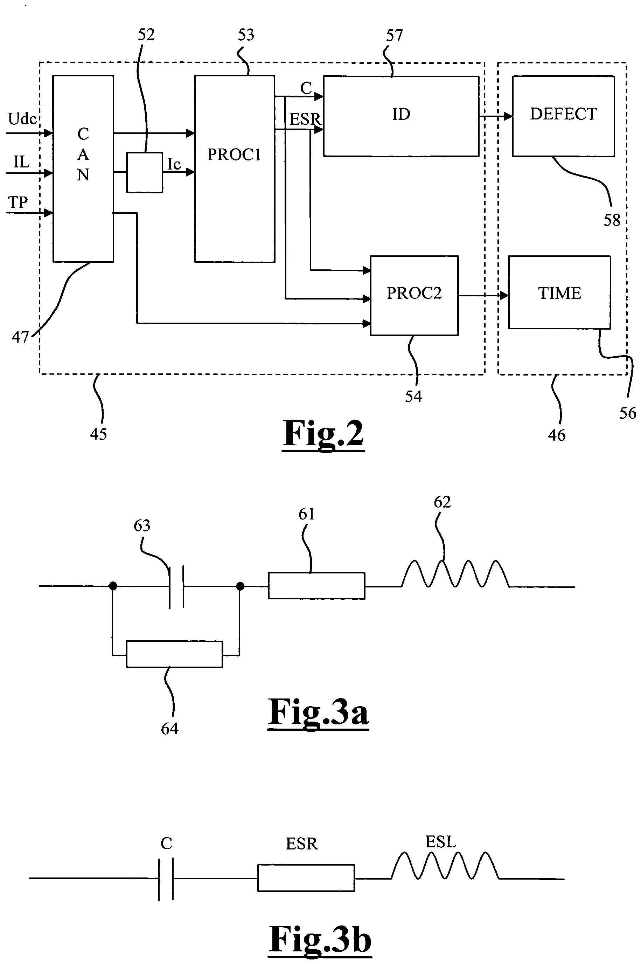

Comme cela est représenté à la figure 1, le dispositif de prédiction 41 comporte, en outre, une unité de traitement 45 ainsi qu'une interface de sortie 46 connectée à l'unité de traitement permettant d'indiquer au moins une information représentative de l'état de vieillissement du condensateur. L'unité de traitement 45 et l'interface de sortie 46 sont représentée de façon plus détaillée à la figure 2. Les moyens de mesure décrits précédemment sont connectés à un convertisseur analogique numérique 47 de l'unité de traitement 45.

La chaine de mesure de la tension Udc de l'ondulation comporte généralement un filtre passe-haut non représenté, par exemple avec une fréquence de coupure de 200 Hz. Ce filtre peut être utilisé pour enlever la composante continue de la tension entre les bornes du condensateur. Une fois cette composante continue enlevée, la chaîne de mesure peut être adaptée pour avoir des valeurs de tension positives et inférieures à 3V à l'entrée de l'unité de traitement, par exemple à l'aide de circuits électroniques à base d'amplificateurs opérationnels.

Dans le mode de réalisation représenté sur la figure 2, la valeur du courant Ic circulant dans le condensateur est déterminée, à l'aide d'un module 52, à partir de la mesure du courant IL circulant dans le bus positif. Le courant Ic circulant dans le condensateur peut être déterminé en faisant la différence entre le courant Id circulant dans la diode 16 et le courant Ich circulant dans la charge 33. Le courant Id circulant dans la diode 16 est généralement dépendant du courant IL circulant dans le bus positif, ainsi que de l'état de l'interrupteur commandé 23. La valeur du courant Ic dans la charge 33 dépend, quant à elle, du type de charge. Dans le cas d'une charge connue, par exemple résistive, la valeur du courant Ic dans la charge peut être considérée comme égale à la moyenne du courant Id circulant dans la diode 16. Dans le cas d'une charge correspondant à un onduleur, c'est-à-dire dans le cas d'un convertisseur complet comprenant un convertisseur du type PFC, tel que représenté à la figure 1, et un onduleur, la valeur du courant Ic dans la charge 33 peut être considérée comme égale au produit de la tension de sortie de l'onduleur et du courant de sortie de l'onduleur divisé par le produit de la tension Uc entre les bornes de contact du condensateur et du rendement globale de l'onduleur. Ainsi, grâce au module 52, il est possible de déterminer la valeur du courant Ic dans le condensateur à partir, entre autres, de la valeur du courant IL circulant dans le bus positif. Dans d'autres modes de réalisation non représentés, il est également possible de mesurer directement la valeur du courant Ic dans le condensateur.

L'unité de traitement 45 comportent des premiers moyens de traitement 53 permettant de déterminer les valeurs d'une résistance série équivalente et de la capacité du condensateur. Pour déterminer la résistance série équivalente du condensateur, le modèle représenté à la figure 3a est utilisé. Ce modèle comporte un certain nombre de paramètres, tels qu'une première résistance 61 montée en série avec une inductance 62 et un condensateur idéal 63 purement capacitif. Dans ce modèle, une résistance de fuite 64 est montée en parallèle avec le condensateur idéal 63. La valeur de la résistance équivalente est donc déterminée à l'aide du modèle équivalent représenté à la figure 3b en fonction des paramètres du modèle de la figure 3a.

Selon un aspect de l'invention, les premiers moyens de traitement 53 permettent, en outre, de déterminer la valeur de la capacité du condensateur. Ainsi, à l'aide du modèle équivalent de la figure 3b, il est possible de déterminer non seulement la valeur de la résistance équivalente, mais également la valeur de la capacité C du condensateur. Ces deux grandeurs, ainsi que l'inductance équivalente ESL, dépendent de la fréquence et de la température du condensateur. Pour des fréquences inférieures à une fréquence de résonnance, l'inductance équivalente devient négligeable et le modèle équivalent comporte seulement la résistance équivalente ESR en série avec le condensateur de capacité C. Dans ce cas, la fonction de transfert liant le courant Ic dans le condensateur à la tension Udc de l'ondulation entre les bornes de contact du condensateur est une fonction du premier ordre comportant, comme paramètres, la résistance équivalente série ESR et la capacité C.

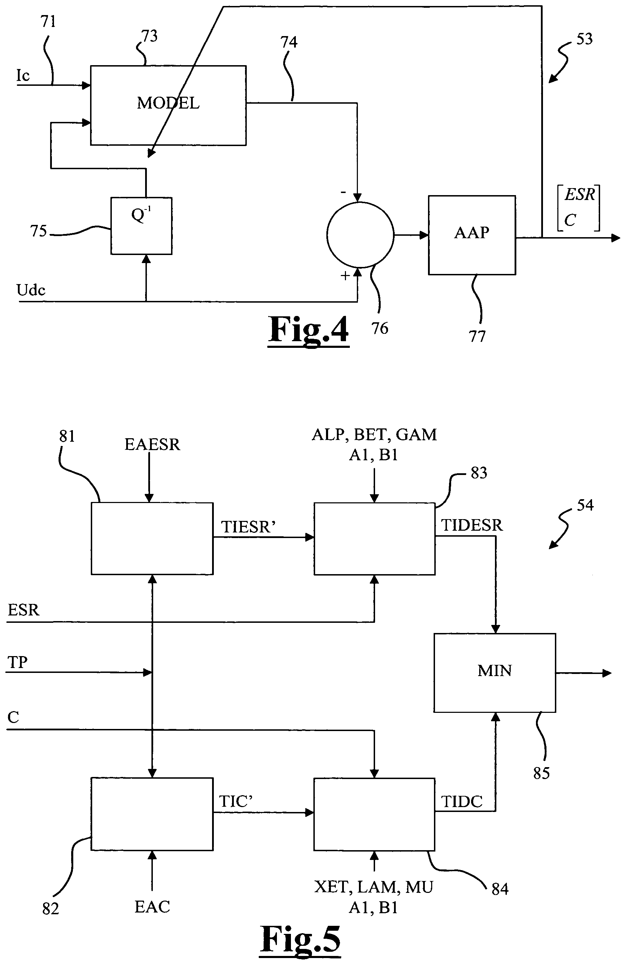

Selon un autre aspect de l'invention, les premiers moyens de traitement 53 sont essentiellement constitués par un filtre numérique permettant de déterminer les valeurs de la résistance équivalente série et de la capacité du condensateur. Comme cela est représenté à la figure 4, le filtre numérique des premiers moyens de traitement 53 est° un filtre de Kalman, en l'occurrence un filtre de Kalman mettant en oeuvre un algorithme de type récursif, par exemple de type moindre carré récursif. A l'aide du filtre de Kalman, il est donc possible de déterminer les paramètres de la fonction de transfert liant le courant Ic dans le condensateur à la tension Udc de l'ondulation entre les bornes de contact du condensateur, c'est-à-dire la résistance équivalente série ESR et la capacité C.

Le filtre numérique des premiers moyens de traitement 53 représenté à la figure 4 comportent une première entrée 71 du courant Ic dans le condensateur et une seconde entrée 72 de la tension Udc de l'ondulation entre les bornes de contact du condensateur. Le filtre comporte également un module 73 de la fonction de transfert liant le courant Ic à la tension Udc. Ce module 73 permet d'estimer en temps réel, ou plus précisément à un pas de temps donné, une première valeur 74 de la tension Udc de l'ondulation aux bornes du condensateur. Cette première valeur 74 de la tension Udc est estimée en fonction du courant Ic dans le condensateur à ce même pas de temps et de la tension Udc de l'ondulation à un pas de temps antérieur. La tension Udc de l'ondulation à un pas de temps antérieur est, quant à elle, déterminée à l'aide d'une fonction retard 75. Durant ce même pas de temps, cette première valeur 74 de la tension Udc est comparée à la mesure de cette même tension Udc à l'aide d'un comparateur 76. Un algorithme d'adaptation paramétrique 77 est utilisé pour réévaluer les paramètres de la fonction de transfert, c'est-à-dire la résistance équivalente série ESR et la capacité C, en fonction de la différence entre la première valeur 74 de la tension Udc et la mesure de cette tension. Les paramètres ainsi réévalués sont ensuite réinjectés dans le module 73 de la fonction de transfert.

Afin de déterminer la résistance équivalente série ESR et la capacité C avec plus de précision, il est préférable d'appliquer aux bornes du condensateur une séquence binaire pseudo aléatoire 79, tel que cela est représenté à la figure 1. Cette séquence binaire pseudo aléatoire peut être un signal de superposition présentant un spectre fréquentiel large, en particulier un spectre de fréquentiel englobant au moins le spectre de fréquences utiles du condensateur, c'est-à-dire un spectre de fréquences couvrant la bande passante de la capacité C et de la résistance équivalente série ESR du condensateur.

Comme cela est représenté à la figure 2, l'unité de traitement 45 comporte des seconds moyens de traitement 54 permettant de déterminer au moins une information représentative de l'état de vieillissement du condensateur à partir d'un modèle de détermination d'une résistance équivalente série théorique ou/et de la capacité théorique dudit condensateur en fonction de la température du condensateur. Cette information représentative de l'état de vieillissement correspond généralement à un nombre d'heures avant la panne. Cette information est déterminée à partir de la mesure de la température TP du condensateur, ainsi que des valeurs, déterminées en temps réel, de la résistance équivalente ESR et de la capacité C. Les seconds moyens de traitement 54 sont représentés de manière plus détaillée à la figure 5.

Pour déterminer une information représentative de l'état de vieillissement du condensateur, on met en oeuvre des modèles de vieillissement permettant de déterminer la résistance équivalente série ESR et la capacité C du condensateur en fonction du temps. La résistance équivalente série ESR et la capacité C peuvent être déterminées à partir de ces modèles de vieillissement en définissant des conditions prédéterminées de défaillance et en utilisant, comme indicateurs, la résistance équivalente ESR et à la capacité C des condensateurs. A titre d'exemple, la condition de défaillance en utilisant la résistance série équivalente ESR comme indicateur peut correspondre à une augmentation de 100% de la valeur de cette résistance équivalente, c'est-à-dire que le condensateur est considéré comme potentiellement défaillant si, lors de son fonctionnement, la valeur de la résistance équivalente série de ce condensateur atteint le double de la valeur initiale. De la même façon, la condition de défaillance en utilisant la capacité C du condensateur comme indicateur peut correspondre à une diminution, par exemple de 20%, de la valeur de la capacité initiale.

Les modèles de vieillissement sont utilisés conjointement avec des modèles de détermination d'une résistance équivalente série théorique ESRt et d'une capacité théorique Ct du condensateur en fonction de la température TP dudit condensateur. La résistance équivalente série théorique ESRt et la capacité théorique Ct correspondent aux valeurs obtenues pour un condensateur sain ou non défaillant.

Les différents modèles de vieillissement, ainsi que les modèles de détermination de la résistance équivalente série théorique et de la capacité théorique, comportent des paramètres qui peuvent être prédéterminés par des tests de vieillissement. Il est donc possible de réaliser préalablement, pour différentes températures de vieillissement TPV, des tests de vieillissement sur le type de condensateur électrolytique à surveiller. Ces tests permettent de déterminer préalablement les paramètres suivants :

- des temps de vieillissement TIVESR, TIVC pour remplir les conditions de défaillance en utilisant respectivement la résistance équivalente série ESR et la capacité C du condensateur comme indicateur,

- une énergie d'activation EAESR, EAC associées respectivement à la résistance équivalente série ESR et à la capacité C du condensateur,

- des coefficients ALP, BET, GAM du modèle de détermination de la résistance série équivalente théorique en fonction de la température du condensateur,

- des coefficients XET, LAM, MU du modèle de détermination de la capacité théorique en fonction de la température du condensateur,

- des coefficients A1, B1 du modèle de vieillissement pour déterminer la résistance série équivalente en fonction du temps, et

- des coefficients E, F du modèle de vieillissement pour déterminer la capacité en fonction du temps.

Les modèles de détermination de la résistance équivalente série théorique et de la capacité théorique en fonction de la température du condensateur peuvent être représentés, à titre d'exemple, par les équations suivantes :

$$ESRt(TP) = ALP + BET * \exp(-TP/GAM)$$

$$Ct(TP) = XET + LAM * TP)$$

A partir des valeurs des temps de vieillissement TIVESR, TIVC prédéterminées pour une température de vieillissement TPV donnée, on peut déterminer un temps de vieillissement TIESR', TIC', en prenant pour indicateur soit la résistance équivalente série ESR, soit la capacité C du condensateur, et ceci pour n'importe quelle température TP de fonctionnement. Pour cela, on utilise généralement des modèles de type Arrhenius. Par exemple, en posant K comme étant la constante de Boltzmann, les équations suivantes peuvent être utilisées :

$$\frac{TIESR'}{TIVESR} = \exp\left[\frac{EAESR * (TPV - TP)}{K * TPV * TP}\right]$$

$$\frac{TIC'}{TIVC} = \exp\left[\frac{EAC * (TPV - TP)}{K * TPV * TP}\right]$$

Comme cela est représenté à la figure 5, les temps de vieillissement TIESR', TIC' sont déterminés par deux modules 81, 82 des seconds moyens de traitement 54 en fonction de la température TP de fonctionnement du condensateur.

Le modèle de vieillissement utilisé pour déterminer la résistance série équivalente ESR du condensateur en fonction du temps présente généralement une fonction exponentielle du temps. Le modèle de vieillissement utilisé pour déterminer la capacité C du condensateur en fonction du temps présente généralement une fonction linéaire du temps. A titre d'exemple, ces modèles peuvent être représentés par les équations suivantes :

$$ESR(TIESR) = ESR(0) * (1 - A1 + A1 * \exp(B1 * TI))$$

$$C(TIC) = C(0) - E * TIC$$

Les valeurs de ESR(0) et de C(0) correspondent respectivement à la résistance série équivalente théorique et à la capacité théorique, c'est-à-dire des valeurs correspondant à un condensateur sain et sans défaillance. Ces valeurs sont déterminées à l'aide des modèles de détermination de la résistance équivalente série théorique et de la capacité théorique en fonction de la température du condensateur, pour une température égale à celle de la température TP de fonctionnement du condensateur.

A partir des modèles de vieillissement et des valeurs de la résistance série équivalente ESR ou de la capacité C, il est possible de déterminer un temps théorique TIESR, TIC correspondant à un temps de vieillissement du condensateur en prenant comme indicateur soit la résistance série équivalente ESR, soit la capacité C.

Comme cela est représenté à la figure 5, les seconds moyens de traitement de l'unité de traitement comporte deux modules 83, 84 de détermination d'une durée de vieillissement TIDESR, TIDC correspondant à la durée restante de fonctionnement avant la défaillance en prenant comme indicateur soit la résistance série équivalente ESR, soit la capacité C. Cette durée est déterminée en soustrayant les temps théorique TIESR, TIC respectivement des temps de vieillissement TIESR', TIC'. Un module de comparaison 85 permet de déterminer la durée de vieillissement TID en sélectionnant la valeur la plus petite entre les durées de vieillissement TIDESR, TIDC déterminées avec la résistance série équivalente ESR et la capacité C comme indicateurs.

Comme cela est représenté à la figure 2, le dispositif de prédiction comporte une interface de sortie 46 connectée à l'unité de traitement 45 et permettant d'indiquer l'information représentative de l'état de vieillissement du condensateur. La durée de vieillissement TID est affichée par le module d'interface 56.

Selon un autre aspect de l'invention, l'interface de sortie 46 permet d'indiquer, en outre, une information représentative de la valeur de la capacité du condensateur ou/et une information représentative d'au moins une cause associée à l'état de vieillissement dudit condensateur en fonction de la valeur de la capacité du condensateur.

Dans le dispositif de prédiction représenté à la figure 2, l'unité de traitement 45 comporte des moyens d'identification 57 d'au moins une cause associée à l'état de vieillissement du condensateur en fonction de la valeur de la capacité dudit condensateur. Les moyens d'identification 57 permettent d'associer, à des variations de la capacité C et de la résistance équivalente série ESR, un mode de défaillance, qui peut lui-même être associé à une cause de défaillance.

A titre d'exemple, une augmentation de la capacité C de 10% en moins d'une seconde peut être associée à un mode de défaillance de type « court-circuit ». Les causes de défaillance associées à ce mode de défaillance peuvent être des défauts dans le processus de fabrication, telles que, par exemple, un court circuit entre les électrodes du condensateur, un défaut d'isolation dans le diélectrique du condensateur, et/ou un défaut d'isolation dans les papiers séparateurs. Les causes de défaillance associées à ce mode de défaillance peuvent également être des défauts de fonctionnement tels que des cycles de charge et de décharges excessifs pouvant provoquer une dégradation de la couche d'oxyde du condensateur.

A titre d'exemple, une augmentation de la résistance équivalente série ESR de 10% en moins d'une seconde combinée à une stagnation de la capacité C à une valeur sensiblement constante peut être associée à un mode de défaillance de type « circuit ouvert ». Les causes de défaillance associées à ce mode de défaillance peuvent être des défauts de fabrication, telles que, par exemple, une contrainte mécanique et/ou une mauvaise connexion des bandes de connections des bornes du condensateur. Les causes de défaillance associées à ce mode de défaillance peuvent également être des défauts de fonctionnement tels que la présence de courants de charge ou de décharge excessifs.

A titre d'exemple, une augmentation de la résistance équivalente série ESR de 100% sur une durée d'une dizaine de milliers d'heures à quelques dizaines de milliers d'heures combinée à une diminution de 20 % de la capacité C sur cette même durée peut être associée à un mode de défaillance de type « vieillissement prématuré ». Les causes de défaillance associées à ce mode de défaillance peuvent être des défauts de fabrication, telles que, par exemple, la présence d'un joint poreux entamant l'étanchéité. Les causes de défaillance associées à ce mode de défaillance peuvent également être des défauts de fonctionnement tels qu'une ondulation de courant excessive provoquant une contrainte thermique importante, la présence de surtension, la présence d'une tension inverse. Les causes de défaillance associées à ce mode de défaillance peuvent également être des défauts de vieillissement normal.

Dans le mode de réalisation représenté à la figure 2, l'interface de sortie permet d'indiquer une information représentative de l'état de vieillissement par le module d'interface 56, ainsi qu'une information représentative de la cause de l'état de vieillissement par le module d'interface 58.

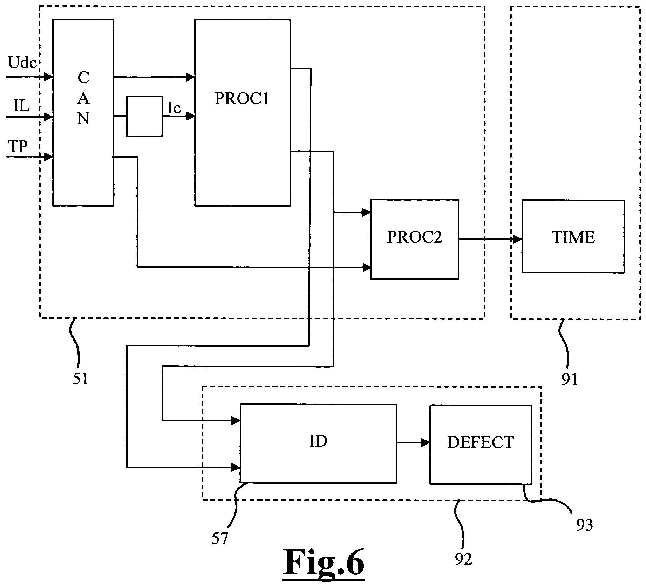

Dans le mode de réalisation représenté à la figure 6, l'interface de sortie 91 permet seulement d'indiquer une information représentative de l'état de vieillissement. Contrairement à la figure 2, l'unité de traitement 51 ne comporte plus de moyens d'identification d'au moins une cause associée à l'état de vieillissement du condensateur. Le dispositif comporte une unité de traitement annexe 92 dans laquelle les moyens d'identification 57 d'au moins une cause associée à l'état de vieillissement du condensateur ont été déportés. Cette unité de traitement annexe est destinée à être connectée à l'interface 91. Un module d'interface 93 dans l'unité de traitement annexe 92 permet d'afficher la cause de défaillance.

Le convertisseur doté d'un tel dispositif de prédiction des défaillances d'un condensateur électrolytiques peut permettre, dans le cas d'une pluralité de condensateurs montés en parallèle, de prédire les défaillances de ladite pluralité de condensateurs. Dans ce cas on détermine une résistance équivalente série qui est égale au rapport de la résistance équivalente série d'un condensateur sur le nombre de condensateurs montés en parallèle. On détermine également une capacité équivalente qui est, quant à elle, égale au produit de la capacité d'un condensateur par le nombre de condensateurs montés en parallèle.

**Revendications**

**1.** Procédé de prédiction de défaillances d'au moins un condensateur électrolytique (31) comprenant :

- la mesure (42) de la tension de l'ondulation (Udc) entre les bornes de contact du condensateur,
- la mesure (43) de la température (TP) du condensateur,
- la détermination (44, 52) du courant (Ic) circulant dans le condensateur,
- la détermination (53) de la valeur d'une résistance équivalente série (ESR) du condensateur,
- la détermination (54) d'au moins une information représentative de l'état de vieillissement du condensateur à l'aide d'un modèle de détermination d'une résistance équivalente série théorique (ESRt) dudit condensateur en fonction de la température du condensateur, et
- l'indication (56) de l'information représentative de l'état de vieillissement du condensateur,

**caractérisé en ce qu'**il comporte la détermination (53) de la valeur de la capacité (C) du condensateur,
**en ce que** les déterminations (53) de la résistance équivalente série et de la capacité sont réalisées à l'aide d'un filtre numérique, et

**en ce qu'**il comporte l'indication (58) d'une information représentative de la valeur de la capacité du condensateur (C) et d'une information représentative d'au moins une cause associée à l'état de vieillissement dudit condensateur en fonction de la valeur de la capacité et de la résistance équivalente série du condensateur.

**2.** Procédé selon la revendication 1, **caractérisé en ce que** le filtre numérique (53) est un filtre de Kalman.

**3.** Procédé selon la revendication 2, **caractérisé en ce que** le filtre de Kalman met en oeuvre un algorithme de type récursif.

**4.** Procédé selon l'une des revendications 1 à 3, **caractérisé en ce qu'**il comporte l'application aux bornes du condensateur (31) d'une séquence binaire pseudo aléatoire.

**5.** Dispositif de prédiction de défaillances (41) d'au moins un condensateur électrolytique (31) comprenant :

- des moyens de mesure (42) de la tension de l'ondulation (Udc) entre les bornes de contact du condensateur,
- des moyens de mesure (43) de la température (TP)du condensateur,
- des moyens de détermination (44, 52) du courant (Ic) circulant dans le condensateur,
- une unité de traitement (45) comportant des premiers moyens de traitement (53) permettant de déterminer la valeur d'une résistance équivalente série (ESR) du condensateur, et des seconds moyens de traitement (54) permettant de déterminer au moins une information représentative de l'état de vieillissement du condensateur à partir d'un modèle de détermination d'une résistance équivalente série théorique dudit condensateur en fonction de la température du condensateur, et
- une interface de sortie (46, 56) connectée à l'unité de traitement et permettant d'indiquer l'information représentative de l'état de vieillissement du condensateur,

**caractérisé en ce que** les premiers moyens de traitement sont essentiellement constitués par un filtre numérique permettant, en outre, de déterminer la valeur de la capacité du condensateur (C), et

**en ce que** l'interface de sortie (46) permet d'indiquer, en outre, une information représentative de la valeur de la capacité du condensateur (C) et une information représentative d'au moins une cause associée à l'état de vieillissement dudit condensateur en fonction de la valeur de la capacité et de la résistance équivalente série du condensateur.

**6.** Dispositif selon la revendication 5, **caractérisé en ce que** l'unité de traitement comporte des moyens d'identification (57) d'au moins une cause associée à l'état de vieillissement du condensateur en fonction de la valeur de la capacité et de la résistance équivalente série dudit condensateur, et **en ce que** l'interface de sortie (46, 58) permet d'indiquer une information représentative d'au moins une cause de l'état de vieillissement.

**7.** Dispositif selon la revendication 5, **caractérisé en ce que** le dispositif comporte une unité de traitement annexe (92) comportant des moyens d'identification (57) d'au moins une cause associée à l'état de vieillissement du condensateur et destiné à être connectés à l'interface de sortie (91).

**8.** Dispositif selon l'une des revendications 5 à 7, **caractérisé en ce que** les premiers moyens de traitement (53) comportent un filtre de Kalman pour déterminer les valeurs de la résistance équivalente série (ESR) du condensateur et de la capacité (C) du condensateur.

**9.** Dispositif selon la revendication 8, **caractérisé en ce que** le filtre de Kalman met en oeuvre un algorithme de type récursif.

**10.** Dispositif selon l'une des revendications 5 à 9, **caractérisé en ce qu'**il comporte des moyens d'application d'une séquence binaire pseudo aléatoire aux bornes du condensateur.

**11.** Convertisseur d'une tension variable en tension continue comprenant au moins une ligne d'alimentation (12), au moins un condensateur électrolytique (31) connecté sur une sortie dudit convertisseur, et un dispositif de prédiction de défaillances (41), **caractérisé en ce que** le dispositif de prédiction de défaillances est selon l'une des revendications 5 à 10 et permet de prédire les défaillances du condensateur électrolytique.

**12.** Convertisseur selon la revendication 11, **caractérisé en ce que** les moyens (52) de détermination du courant circulant dans le condensateur sont connectés à des moyens de mesures (44, 47) d'un courant (IL) sur la ligne d'alimentation et à des moyens de mesures d'un courant dans une charge électrique.

13. Convertisseur selon l'une des revendications 11 ou 12, **caractérisé en ce qu'**il comporte une pluralité de condensateurs électrolytiques montés en parallèle, le dispositif de prédiction permettant de prédire les défaillances de ladite pluralité de condensateurs électrolytiques.

14. Alimentation sans interruption comportant un convertisseur (11) d'une tension variable en tension continue et un onduleur, **caractérisé en ce que** le convertisseur est selon l'une des revendications 11 à 13, l'onduleur étant connecté sur la sortie dudit convertisseur.

**Patentansprüche**

1. Vorhersageverfahren von Ausfällen mindestens eines Elektrolytkondensators (31), das enthält:

   - die Messung (42) der Spannung der Welligkeit (Udc) zwischen den Kontaktklemmen des Kondensators,
   - die Messung (43) der Temperatur (TP) des Kondensators,
   - die Bestimmung (44, 52) des im Kondensator fließenden Stroms (Ic),
   - die Bestimmung (53) des Werts eines Reihenwirkwiderstands (ESR) des Kondensators,
   - die Bestimmung (54) mindestens einer für den Alterungszustand des Kondensators repräsentativen Information mit Hilfe eines Bestimmungsmodells eines theoretischen Reihenwirkwiderstands (ESRt) des Kondensators abhängig von der Temperatur des Kondensators, und
   - die Anzeige (56) der für den Alterungszustand des Kondensators repräsentativen Information,

   **dadurch gekennzeichnet, dass** es die Bestimmung (53) des Werts der Kapazität (C) des Kondensators aufweist, dass die Bestimmung (53) des Reihenwirkwiderstands und der Kapazität mit Hilfe eines digitalen Filters durchgeführt werden, und
   dass es die Anzeige (58) einer für den Wert der Kapazität des Kondensators (C) repräsentativen Information und einer für mindestens eine dem Alterungszustand des Kondensators zugeordnete Ursache repräsentativen Information abhängig vom Wert der Kapazität und vom Reihenwirkwiderstand des Kondensators aufweist.

2. Verfahren nach Anspruch 1, **dadurch gekennzeichnet, dass** das digitale Filter (53) ein Kalman-Filter ist.

3. Verfahren nach Anspruch 2, **dadurch gekennzeichnet, dass** das Kalman-Filter einen Algorithmus vom rekursiven Typ anwendet.

4. Verfahren nach einem der Ansprüche 1 bis 3, **dadurch gekennzeichnet, dass** es das Anlegen einer pseudozufälligen Bitfolge an die Klemmen des Kondensators (31) aufweist.

5. Vorhersagevorrichtung (41) von Ausfällen mindestens eines Elektrolytkondensators (31), die enthält:

   - Messeinrichtungen (42) der Spannung der Welligkeit (Udc) zwischen den Kontaktklemmen des Kondensators,
   - Messeinrichtungen (43) der Temperatur (TP) des Kondensators,
   - Bestimmungseinrichtungen (44, 52) des im Kondensator fließenden Stroms (Ic),
   - eine Verarbeitungseinheit (45), die erste Verarbeitungseinrichtungen (53), die es ermöglichen, den Wert eines Reihenwirkwiderstands (ESR) des Kondensators zu bestimmen, und zweite Verarbeitungseinrichtungen (54) aufweist, die es ermöglichen, mindestens eine für den Alterungszustand des Kondensators repräsentative Information ausgehend von einem Bestimmungsmodell eines theoretischen Reihenwirkwiderstands des Kondensators abhängig von der Temperatur des Kondensators zu bestimmen, und
   - eine Ausgangsschnittstelle (46, 56), die mit der Verarbeitungseinheit verbunden ist und es ermöglicht, die für den Alterungszustand des Kondensators repräsentative Information anzuzeigen,

   **dadurch gekennzeichnet, dass** die ersten Verarbeitungseinrichtungen hauptsächlich aus einem digitalen Filter bestehen, das es außerdem ermöglicht, den Wert der Kapazität des Kondensators (C) zu bestimmen, und dass die Ausgangsschnittstelle (46) es ermöglicht, außerdem eine für den Wert der Kapazität des Kondensators (C) repräsentative Information und eine für mindestens eine dem Alterungszustand des Kondensators zugeordnete Ursache repräsentative Information abhängig vom Wert der Kapazität und des Reihenwirkwiderstands des Kondensators anzuzeigen.

**6.** Vorrichtung nach Anspruch 5, **dadurch gekennzeichnet, dass** die Verarbeitungseinheit Erkennungseinrichtungen (57) mindestens einer dem Alterungszustand des Kondensators zugeordneten Ursache abhängig vom Wert der Kapazität und des Reihenwirkwiderstands des Kondensators aufweist, und dass die Ausgangsschnittstelle (46, 58) es ermöglicht, eine für mindestens eine Ursache des Alterungszustands repräsentative Information anzuzeigen.

**7.** Vorrichtung nach Anspruch 5, **dadurch gekennzeichnet, dass** die Vorrichtung eine zugehörige Verarbeitungseinheit (92) aufweist, die Erkennungseinrichtungen (57) mindestens einer dem Alterungszustand des Kondensators zugeordneten Ursache aufweist und dazu bestimmt ist, mit der Ausgangsschnittstelle (91) verbunden zu werden.

**8.** Vorrichtung nach einem der Ansprüche 5 bis 7, **dadurch gekennzeichnet, dass** die ersten Verarbeitungseinrichtungen (53) ein Kalman-Filter aufweisen, um die Werte des Reihenwirkwiderstands (ESR) des Kondensators und der Kapazität (C) des Kondensators zu bestimmen.

**9.** Vorrichtung nach Anspruch 8, **dadurch gekennzeichnet, dass** das Kalman-Filter einen Algorithmus vom rekursiven Typ verwendet.

**10.** Vorrichtung nach einem der Ansprüche 5 bis 9, **dadurch gekennzeichnet, dass** sie Einrichtungen zum Anlegen einer pseudo-zufälligen Bitfolge an die Klemmen des Kondensators aufweist.

**11.** Wandler einer variablen Spannung in Gleichspannung, der mindestens eine Versorgungsleitung (12), mindestens einen Elektrolytkondensator (31), der an einen Ausgang des Wandlers angeschlossen ist, und eine Vorrichtung zur Vorhersage von Ausfällen (41) enthält, **dadurch gekennzeichnet, dass** die Vorrichtung zur Vorhersage von Ausfällen einem der Ansprüche 5 bis 10 entspricht und es ermöglicht, die Ausfälle des Elektrolytkondensator vorherzusagen.

**12.** Wandler nach Anspruch 11, **dadurch gekennzeichnet, dass** die Einrichtungen (52) zur Bestimmung des im Kondensator fließenden Stroms mit Messeinrichtungen (44, 47) eines Stroms (IL) in der Versorgungsleitung und mit Messeinrichtungen eines Stroms in einer elektrischen Ladung verbunden sind.

**13.** Wandler nach einem der Ansprüche 11 oder 12, **dadurch gekennzeichnet, dass** er eine Vielzahl von parallelgeschalteten Elektrolytkondensatoren aufweist, wobei die Vorhersagevorrichtung es ermöglicht, die Ausfälle der Vielzahl von Elektrolytkondensatoren vorherzusagen.

**14.** Unterbrechungsfreie Versorgung, die einen Wandler (11) einer variablen Spannung in Gleichspannung und einen Wechselrichter aufweist, **dadurch gekennzeichnet, dass** der Wandler einem der Ansprüche 11 bis 13 entspricht, wobei der Wechselrichter mit dem Ausgang des Wandlers verbunden ist.

**Claims**

**1.** Method for predicting failures of at least one electrolytic capacitor (31), comprising:

- measuring (42) the voltage of the ripple (Udc) between the contact terminals of the capacitor;
- measuring (43) the temperature (TP) of the capacitor;
- determining (44, 52) the current (Ic) flowing through the capacitor;
- determining (53) the value of an equivalent series resistance (ESR) of the capacitor;
- determining (54) at least one piece of information that is representative of the state of ageing of the capacitor using a model for determining a theoretical equivalent series resistance (ESRt) of said capacitor depending on the temperature of the capacitor; and
- indicating (56) information that is representative of the state of ageing of the capacitor,

**characterized in that** it includes determining (53) the value of the capacitance (C) of the capacitor,
**in that** the equivalent series resistance and the capacitance are determined (53) using a digital filter, and
**in that** it includes indicating (58) a piece of information that is representative of the value of the capacitance of the capacitor (C) and a piece of information that is representative of at least one cause associated with the state of ageing of said capacitor depending on the value of the capacitance and of the equivalent series resistance of the capacitor.

**2.** Method according to Claim 1, **characterized in that** the digital filter (53) is a Kalman filter.

**3.** Method according to Claim 2, **characterized in that** the Kalman filter implements a recursive algorithm.

**4.** Method according to one of Claims 1 to 3, **characterized in that** it includes applying, to the terminals of the capacitor (31), a pseudo-random binary sequence.

**5.** Device (41) for predicting failures of at least one electrolytic capacitor (31), comprising:

- means (42) for measuring the voltage of the ripple (Udc) between the contact terminals of the capacitor;
- means (43) for measuring the temperature (TP) of the capacitor;
- means (44, 52) for determining the current (Ic) flowing through the capacitor;
- a processing unit (45) including first processing means (53) allowing the value of an equivalent series resistance (ESR) of the capacitor to be determined, and second processing means (54) allowing at least one piece of information that is representative of the state of ageing of the capacitor to be determined on the basis of a model for determining a theoretical equivalent series resistance of said capacitor depending on the temperature of the capacitor; and
- an output interface (46, 56) that is connected to the processing unit and that allows information that is representative of the state of ageing of the capacitor to be indicated,

**characterized in that** the first processing means essentially consist of a digital filter furthermore allowing the value of the capacitance of the capacitor (C) to be determined, and

**in that** the output interface (46) furthermore makes it possible to indicate a piece of information that is representative of the value of the capacitance of the capacitor (C) and a piece of information that is representative of at least one cause associated with the state of ageing of said capacitor depending on the value of the capacitance and of the equivalent series resistance of the capacitor.

**6.** Device according to Claim 5, **characterized in that** the processing unit includes means (57) for identifying at least one cause associated with the state of ageing of the capacitor depending on the value of the capacitance and of the equivalent series resistance of said capacitor, and **in that** the output interface (46, 58) allows a piece of information that is representative of at least one cause of the state of ageing to be indicated.

**7.** Device according to Claim 5, **characterized in that** the device includes an appended processing unit (92) that includes means (57) for identifying at least one cause associated with the state of ageing of the capacitor and that is intended to be connected to the output interface (91).

**8.** Device according to one of Claims 5 to 7, **characterized in that** the first processing means (53) include a Kalman filter for determining the values of the equivalent series resistance (ESR) of the capacitor and of the capacitance (C) of the capacitor.

**9.** Device according to Claim 8, **characterized in that** the Kalman filter implements a recursive algorithm.

**10.** Device according to one of Claims 5 to 9, **characterized in that** it includes means for applying a pseudo-random binary sequence to the terminals of the capacitor.

**11.** AC/DC converter comprising at least one supply line (12), at least one electrolytic capacitor (31) connected to an output of said converter, and a failure-predicting device (41), **characterized in that** the failure-predicting device is according to one of Claims 5 to 10 and allows the failures of the electrolytic capacitor to be predicted.

**12.** Converter according to Claim 11, **characterized in that** the means (52) for determining the current flowing through the capacitor are connected to means (44, 47) for measuring a current (IL) on the supply line and to means for measuring a current in an electrical load.

**13.** Converter according to either of Claims 11 and 12, **characterized in that** it includes a plurality of electrolytic capacitors mounted in parallel, the predicting device allowing the failures of said plurality of electrolytic capacitors to be predicted.

**14.** Uninterruptible power supply including an AC/DC converter (11) and an inverter, **characterized in that** the converter is according to one of Claims 11 to 13, the inverter being connected to the output of said converter.

**Fig.1**

**Fig.2**

**Fig.3a**

**Fig.3b**

**Fig.4**

**Fig.5**

**Fig.6**

**EP 2 056 116 B1**

**RÉFÉRENCES CITÉES DANS LA DESCRIPTION**

**Documents brevets cités dans la description**

- EP 1198715 A